# EUROPEAN PATENT SPECIFICATION

(11) **EP 2 873 526 B1**
(45) Date of publication and mention of the grant of the patent: **19.04.2017**
(21) Application number: 12883458.7
(22) Date of filing: 29.08.2012
(51) Int. Cl.: H05K 3/12, B41F 15/42, B41F 15/46, B41F 15/08, H05K 3/34

(54) **PRINTING MACHINE**
DRUCKMASCHINE
MACHINE D'IMPRESSION

(43) Date of publication of application: 20.05.2015
(73) Proprietor: Yamaha Hatsudoki Kabushiki Kaisha, Iwata-shi, Shizuoka-ken (JP)
(72) Inventor: SATO Hidetoshi, Iwata-shi Shizuoka-ken 438-8501 (JP); MORITA Mitsuharu, Iwata-shi Shizuoka-ken 438-8501 (JP)
(74) Representative: Müller-Boré & Partner Patentanwälte PartG mbB
(86) International application number: PCT/JP2012/071880
(87) International publication number: WO 2014/033861

(56) References cited:
- DE-A1- 19 624 442
- JP-A- H05 338 112
- JP-A- 2001 315 304
- JP-A- 2001 315 304
- JP-A- 2006 062 209
- JP-A- 2006 062 209
- JP-A- 2007 106 103
- JP-A- 2011 000 757
- JP-A- 2011 000 757
- US-A- 3 845 712
- US-A- 5 809 608

## Description

### Technical Field

The present invention relates to a printing machine that prints solder on a circuit board.

### Background Art

Conventionally, printing machines have been used to print cream solder on a surface of a circuit board before electronic components are mounted. In the printing machine, the cream solder is printed on the circuit board by disposing a mask, including a printing opening, on an upper surface of the circuit board, loading the cream solder, in a form of a paste, onto an upper surface of the mask, and moving the cream solder from one side of the upper surface of the mask to the other by a squeegee. In the printing step, the mask may be replaced in accordance with the type of the circuit board. Here, an operation of transferring the cream solder remaining on the upper surface of the mask to an upper surface of a new mask by a spatula is performed.

However, in this operation, the transfer of the cream solder has to be implemented one at a time using the spatula for multiple times. Thus, a cumbersome and time-consuming operation is required. Furthermore, since the shape of the cream solder is ruined in the course of transferring, an operation of reshaping the cream solder is required before the printing is started by using the new mask. A printing machine including a solder gathering squeegee has been developed (see, for example Japanese Unexamined Patent Publication No. 2008-109159). The solder gathering squeegee moves the cream solder to a predetermined portion while the printing is in process on the circuit board on a plurality of sets of rails.

The printing machine (Dual track stenciling printing machine) includes a solder gathering squeegee arm including a wiping squeegee, a distributing squeegee, and a s solder gathering head shaped like a shovel. The wiping squeegee moves the cream solder. The distributing squeegee is disposed slightly above the wiping squeegee while being apart from each other in a movement direction and moves together with the wiping squeegee. The solder gathering squeegee head is disposed on a lower end of a frame member extending in an upper and lower direction, and horizontally extends toward the wiping squeegee and the distributing squeegee. The solder gathering head is moved toward the wiping squeegee that is moving the cream solder, whereby the cream solder positioned between the wiping squeegee and the distributing squeegee can be loaded onto the solder gathering head. By moving the solder gathering arm in this state, the solder can be conveyed to a predetermined position.

JP 2001 315304 A discloses a printing machine according to the preamble of claim 1 and a corresponding method for returning a paste. The method comprises the steps of raising a squeegee to an intermediate point of a height position where a lower edge of a height position between a height position at a sliding time of the squeegee at a slide finishing end and a height position at a paste conveying time to a slide starting end is contacted with a screen in a non-pressed state, thereafter directing a scoop toward the squeegee, and thereby scooping up a thick film print paste.

### Summary of Invention

However, in the printing machine described above, the wiping squeegee is formed of polyurethane, and the distributing squeegee is formed of Teflon (registered trademark). The cream solder in a form of a paste has high wettability against these materials, and thus is likely to attach to the wiping squeegee and the distributing squeegee. As a result, the solder attached to the wiping squeegee and the distributing squeegee might drip off within a printing operation range.

The present invention is made to address the problems described above, and an object of the present invention is to provide a printing machine including a solder scraping unit that can achieve shorter setup time by loading and unloading solder at once without ruining the shape of the solder and can further prevent attaching of the solder.

To achieve the object, the printing machine according to the present invention has a configuration feature described in claim 1.

In the printing machine according to the present invention, the scraping squeegee and the scooping squeegee reciprocate together with the printing squeegee, and can move toward and away from each other. Thus, the solder pushed on one side on the upper surface of the mask by the printing squeegee can be transferred at once by being sandwiched and scooped by the scraping squeegee and the scooping squeegee. Because the solder can be transferred at once as described above, a shorter transferring time for the solder at the time of replacing the mask can be achieved. The transferring can be carried out without ruining the shape of the solder. Thus, the solder needs not to be reshaped when the new mask is used, whereby an attempt to achieve shorter solder rolling time can be facilitated.

The fabric or the sponge with recesses and protrusions is attached to the scraping squeegee, so that the solder is less likely to attach to the scraping squeegee. This is achieved by attaching the material with recesses and the protrusions to make a contact area between the scraping squeegee and the solder small. Specifically, the cream solder has high wettability against a material generally used as the scraping squeegee and thus is likely to attach to the scraping squeegee. With the fabric or the sponge with recesses and protrusions attached on the surface, the cream solder does not sink into the bottom of the recess. The one direction referred to in the present invention is a direction including both ways in a left and right direction, a front and back direction.

The printing machine according to the present invention has another configuration feature described below. Specifically, a frame is disposed on an outer perimeter of the mask, and the scraping squeegee and the scooping squeegee are able to be raised to or above the height of the frame of the mask. In the present invention, the scraping squeegee and the scooping squeegee can be raised and lowered between the upper surface of the mask and an upper side of the frame. Thus, by raising the scraping squeegee and the scooping squeegee above the frame at the time of replacing the mask, the mask can be easily replaced while the solder is being held by the scraping squeegee and the scooping squeegee. By raising the scraping squeegee and the scooping squeegee above the frame at the time of printing performed by the printing squeegee, the scraping squeegee and the scooping squeegee can be prevented from being in the way of the printing operation.

The printing machine according to the present invention has a further configuration feature that the scraping squeegee and the scooping squeegee are able to be separately raised. According to the present invention, the solder can be loaded onto the scooping squeegee by using the surface of the scraping squeegee facing the scooping squeegee at the time of scooping the solder. When the solder is unloaded, the solder can be unloaded from the scooping squeegee to be supplied onto the mask by using the surface of the scraping squeegee opposite to the surface facing the scooping squeegee.

In the printing machine according to the present invention the fabric or the sponge having recesses and protrusions is also attached to an opposite surface of the scraping squeegee with respect to the surface that faces the scooping squeegee. According to the present invention, the solder is less likely to attach to the scraping squeegee also at the time when an operation of supplying the solder to the mask is performed.

A manual solder scooping tool may be used in a conventional printing machine. The solder scooping tool in this case is a solder scooping tool held by an operator with his or her hand for scooping the solder on the mask of the printing machine. The solder scooping tool may include a scooping tool for scooping the solder on an upper surface of the mask and a scraping tool for loading the solder onto the scooping tool. A fabric or a sponge having recesses and protrusions may be attached to a surface of the scraping tool.

With the solder scooping tool, the solder can be loaded and unloaded onto and from the mask at once, whereby the solder can be transferred in a shorter period of time. The solder can be loaded and unloaded without having the shape ruined, and thus needs not to be reshaped for the next operation. Thus, an attempt to shorten the solder rolling rime can be facilitated. Furthermore, the solder can be prevented from attaching to the scraping tool, whereby the scraping tool can be efficiently reused. The solder is loaded and unloaded onto and from the scooping tool by the scraping tool, and thus the scraping tool prevents the solder from attaching to the scooping tool.

### Brief Description of Drawings

[Fig. 1] Fig. 1 is a cross-sectional view of a printing machine according to an embodiment of the present invention.
[Fig. 2] Fig. 2 is a side view of a scraping squeegee.
[Fig. 3] Fig. 3 is a cross-sectional view of a main portion of the printing machine in a state where the scraping squeegee and a scooping squeegee are lowered while being apart from each other.

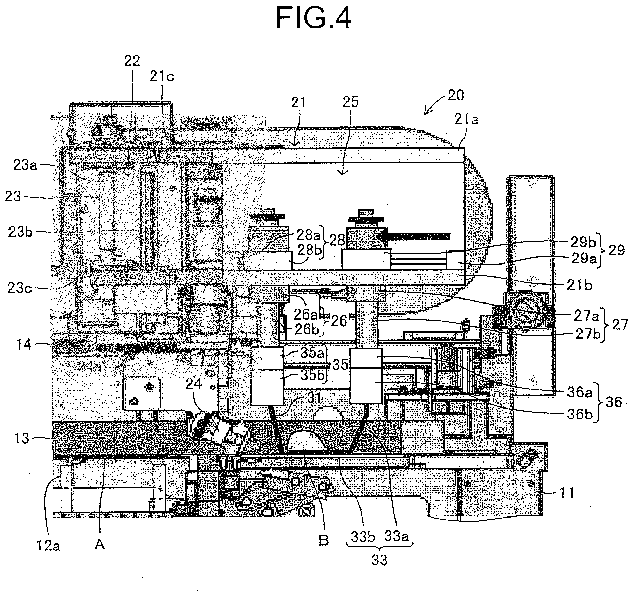

[Fig. 4] Fig. 4 is a cross-sectional view of the main portion of the printing machine in a state where cream solder is scooped by the scooping squeegee that is moved toward the scraping squeegee.
[Fig. 5] Fig. 5 is a cross-sectional view of the main portion of the printing machine in a state where the cream solder is lifted by the scraping squeegee and the scooping squeegee.
[Fig. 6] Fig. 6 is a cross-sectional view of the main portion of the printing machine in a state where the scooping squeegee is lowered and the scraping squeegee is moved toward the scooping squeegee.

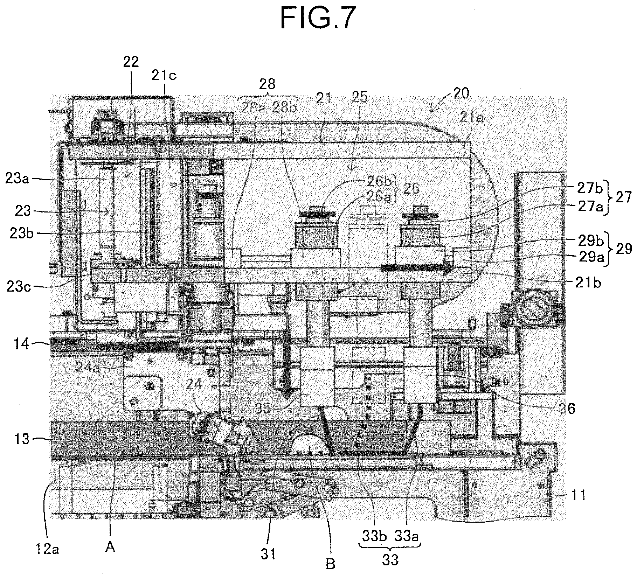

[Fig. 7] Fig. 7 is a cross-sectional view of the main portion of the printing machine in a state where the scraping squeegee is lowered and the scooping squeegee is separated from the scraping squeegee to unload the solder.
[Fig. 8] Fig. 8 is a cross-sectional view of the main portion of the printing machine in a state where the scraping squeegee and the scooping squeegee are raised and the scooping squeegee is disposed adjacent to the scraping squeegee.
[Fig. 9] Fig. 9 is a perspective view showing a solder scooping tool.
[Fig. 10] Fig. 10 is a cross-sectional view of a printing machine in which the solder scooping tool is used.

### Description of Embodiments

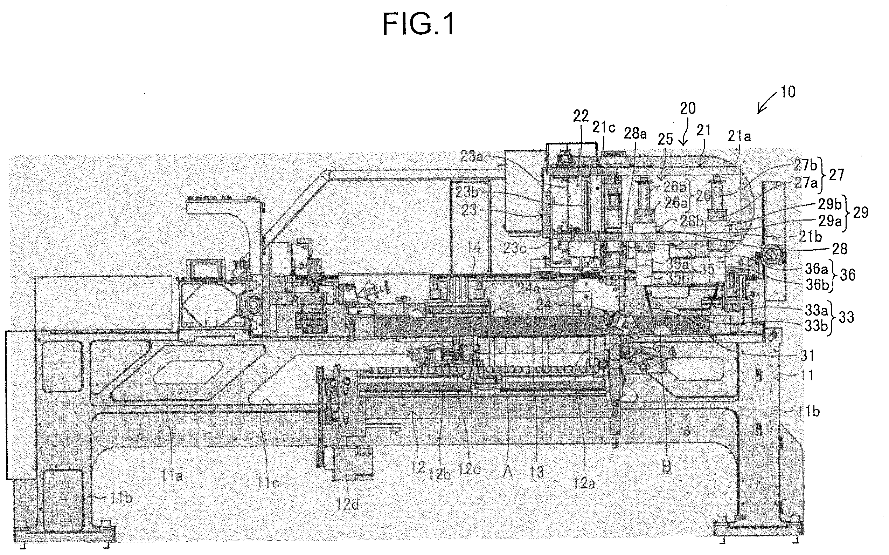

An embodiment of the present invention is described by referring to the drawings. Fig. 1 shows a printing machine 10 according to the embodiment. The printing machine 10 is a device for printing cream solder B, in a form of a paste, on a surface of a printed-circuit board A. The printing machine 10 includes a base 11, an installing device 12, a mask 13, and a squeegee unit 20. The installing device 12 is disposed on the base 11 and is used for installing the printed-circuit board A at a predetermined installation position. The mask 13 is disposed on an upper side of the installation position of the printed-circuit board A in a replaceable manner. The squeegee unit 20 is disposed on the upper side of the mask 13 and reciprocates in an X axis direction (the left and right direction in Fig. 1) by an operation of a driving device. In the description of this embodiment below, left and right, front and back, and upper and lower directions are based on Fig. 1.

The base 11 is formed with leg portions 11b disposed on both left and right sides of a main body 11a. The main body 11 a is provided with a wide opening 11c formed through the front and back direction, and an opening formed through the upper and lower direction. Although not shown in the figure, a carry-in conveyer and a carry-out conveyer are respectively disposed on front and back sides of the opening 11c. The installing device 12 is disposed between the carry-in conveyer and the carry-out conveyer. The printed-circuit board A is carried into the installing device 12 by the carry-in conveyer, and carried out by the carry-out conveyer after being subjected to a printing process. The installing device 12 positions and fixes the printed-circuit board A, carried in by the carry-in conveyer, on a lower surface of the mask 13. The printed-circuit board A is supported by the installing device 12 in such a manner as to be displaceable in the left and right, the front and back, and the upper and lower directions as well as in a rotational direction on a horizontal plane.

The installing device 12 includes a supporting fixing unit 12a and a movement mechanism. The supporting fixing unit 12a includes a supporting mechanism that supports the printed-circuit board A and a clamp mechanism that grasps the printed-circuit board A. The movement mechanism moves the supporting fixing unit 12a in each direction. The supporting mechanism of the supporting fixing unit 12a uses a supporting pin to support the printed-circuit board A from below. The clamp mechanism clamps the printed-circuit board A from left and right with a pair of grasping pieces. The movement mechanism includes an X axis driving unit, a Y axis driving unit, a Z axis driving unit, and an R axis driving unit. The X axis driving unit includes a guide rail 12b, a ball screw 12c, a servomotor 12d, and the like and moves the supporting fixing unit 12a in the X direction. The Y axis driving unit moves the supporting fixing unit 12a in a Y axis direction (the front and back direction). The Z axis driving unit moves the supporting fixing unit 12a in a Z axis direction (the upper and lower direction). The R axis driving unit rotates the supporting fixing unit 12a about the Z axis.

The mask 13 is formed by attaching a mask sheet, including a plurality of printing openings, on a lower end opening of a rectangular frame member. The mask 13 is disposed to close the opening formed through the main body 11a of the base 11 in the upper and lower direction. As shown in Fig. 1, the mask 13 is disposed from a portion slightly on the left side of the center of the main body 11a in the left and right direction and to a portion adjacent to a right end portion of the main body 11a. A plurality of the masks 13, having different numbers and arrangements of printing openings, are prepared. Thus, the mask 13 is replaced as appropriate in accordance with the printed-circuit board A to be printed.

A linear guide 14 is disposed on the upper side of the base 11. The linear guide 14 is disposed across supporting portions, apart from each other in the left and right direction, and is positioned on the upper side of the mask 13. The squeegee unit 20 is moveably attached to the linear guide 14. The squeegee unit 20 is reciprocated in the left and right direction along the linear guide 14 by an operation of a driving device (not shown). The squeegee unit 20 is formed by assembling a squeegee head 22 and a solder elevation head 25 in a head supporting portion 21 in a form of a frame. The head supporting portion 21 is formed by coupling upper and lower surface portions 21a and 21b, in a form of a plate and disposed while being apart from each other in the upper and lower direction, through a coupling piece 21c. A thin and long hole (not shown), extending in the left and right direction, is formed in the vertical direction through a portion of the lower surface portion 21b where the solder elevation head 25 is disposed.

The squeegee head 22 includes an elevation mechanism 23 and a squeegee holding unit 24a. The elevation mechanism 23 includes a ball screw 23a and a guide shaft 23b disposed between the upper and the lower surface portions 21a and 21b in the upper and lower direction. The squeegee holding unit 24a is raised or lowered through a coupling piece 23c by an operation of the elevation mechanism 23. A printing squeegee 24 is attached to the squeegee holding unit 24a. The printing squeegee 24 moves a cream solder B along an upper surface (mask sheet) of the mask 13. The printing squeegee 24 is formed of a thin and long member having a width in the front and back direction slightly longer than the printed-circuit board A. A distal end of the printing squeegee 24 in a forward movement direction is formed of a flat plate member.

The plate member at the distal end of the printing squeegee 24 is formed of hard urethane or stainless steel, and moreover formed in such a manner that no gap is formed between the plate member in contact with the upper surface of the mask 13 and a portion other than the printing opening. The printing squeegee 24 is supported by the squeegee holding unit 24a through a shaft, and is rotatable in a direction about the shaft.

The solder elevation head 25 is disposed on a right side of the squeegee head 22 in the head supporting portion 21, and includes elevation cylinders 26 and 27, driving cylinders 28 and 29, a scraping squeegee 31, and a scooping squeegee 33. The elevation cylinder 26 includes a cylindrical cylinder main body 26a extending in the upper and lower direction and a shaft 26b that penetrates the inside of the cylinder main body 26a and moves in the upper and lower direction with respect to the cylinder main body 26a. The cylinder main body 26a is positioned in the long hole in the lower surface portion 21b. Similarly, the elevation cylinder 27 includes a cylinder main body 27a and a shaft 27b. The cylinder main body 27a is positioned in the long hole in the lower surface portion 21b.

The driving cylinder 28 includes a cylinder main body 28a and a movable holding unit 28b. The cylinder main body 28a is fixed at a center portion of an upper surface of the lower surface portion 21b. The movable holding unit 28b can reciprocate in the right direction from the cylinder main body 28a. A holding portion that has a form of a ring and holds the cylinder main body 26a of the elevation cylinder 26 is formed at a distal end the movable holding unit 28b. The driving cylinder 28 reciprocates the movable holding unit 28b, and thus moves the elevation cylinder 26 in the left and right direction along the long hole of the lower surface portion 21b.

The driving cylinder 29 includes a cylinder main body 29a and a movable holding unit 29b. The cylinder main body 29a is fixed at a right end of the upper surface of the lower surface portion 21b. The movable holding unit 29b can reciprocate in the left direction from the cylinder main body 29a. A holding portion that has a form of a ring and holds the cylinder main body 27a of the elevation cylinder 27 is formed at a distal end of the movable holding unit 29b. The driving cylinder 29 reciprocates the movable holding unit 29b, and thus moves the elevation cylinder 27 in the left and right direction along the long hole of the lower surface portion 21b. Thus, the elevation cylinder 26 and the elevation cylinder 27 are moved toward and away from each other along the long hole of the lower surface portion 21b.

The scraping squeegee 31 is detachably attached to the elevation cylinder 26 through an attachment jig 35. The scooping squeegee 33 is detachably attached to the elevation cylinder 27 through an attachment jig 36. The attachment jig 35 includes an upper engagement portion 35a and a lower engagement portion 35b that are detachably attached to each other. The upper engagement portion 35a is attached to a lower end of the shaft 26b of the elevation cylinder 26. The lower engagement portion 35b is attached to an upper end portion of the scraping squeegee 31. Similarly, the attachment jig 36 includes an upper engagement portion 36a and a lower engagement portion 36b that are detachably attached to each other. The upper engagement portion 36a is attached to a lower end of the shaft 27b of the elevation cylinder 27. The lower engagement portion 36b is attached to an upper end portion of the scooping squeegee 33.

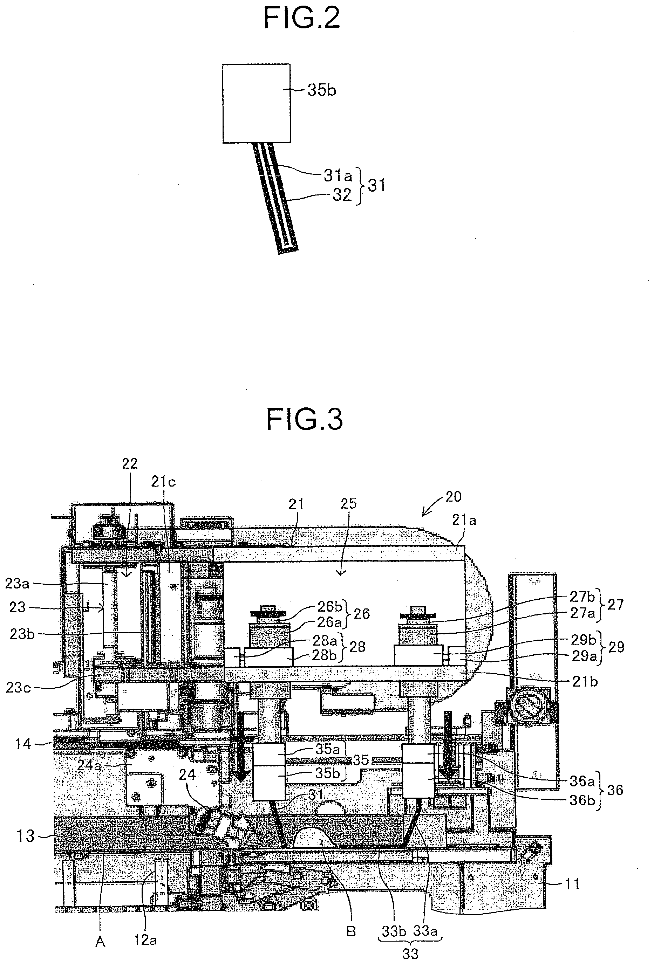

When the mask 13 needs to be replaced, the scraping squeegee 31 and the scooping squeegee 33 transfer the cream solder B remaining on the mask 13 onto a new mask 13. The scraping squeegee 31 and the scooping squeegee 33 are separately moved in the upper and lower direction and in the left and right direction by operations of the elevation cylinders 26 and 27 and the driving cylinders 28 and 29. As shown in Fig. 2, the scraping squeegee 31 is provided in a plate form, the lower end of which is positioned further toward the right side than the upper end thereof coupled to the lower engagement portion 35b. The length of the scraping squeegee 31 in the front and back direction is set to be substantially the same as the printing squeegee 24. The scraping squeegee 31 includes a main body 31a and a covering portion 32. The main body 31a is formed of hard urethane or stainless steel, as is the case of the printing squeegee 24. The covering portion 32 has a form of a sheet and covers both left and right surfaces and a lower end portion of the main body 31a. The covering portion 32 is formed of a non-woven fabric with a surface having recesses and protrusions.

The scooping squeegee 33 includes a vertical piece 33a and a horizontal piece 33b. The vertical piece 33a is coupled to the lower engagement portion 36b. The horizontal piece 33b extends in the left direction from a lower end of the vertical piece 33a. The vertical piece 33a has a form of a plate inclined to have a lower end positioned more on the left side than an upper end. The horizontal piece 33b horizontally extends toward a lower end of the scraping squeegee 31 from the lower end of the vertical piece 33a. The width of the scooping squeegee 33 in the front and back direction is slightly longer than the width of the scraping squeegee 31 in the front and back direction.

Low wall portions (not shown) that prevent the cream solder B from spilling are formed on front and back sides of the horizontal piece 33b. The scooping squeegee 33 is also formed of hard urethane or stainless steel. The scooping squeegee 33 scoops the cream solder B onto the horizontal piece 33b. The scraping squeegee 31 moves the cream solder B on the mask 13 onto the horizontal piece 33b, or moves the cream solder B on the horizontal piece 33b onto the mask 13.

The cream solder B is printed on the surface of the printed-circuit board A by using the printing machine 10 having the configuration described above, in the following manner. First of all, the printed-circuit board A conveyed from the carry-in conveyer is disposed in the installing device 12 to be positioned on the lower surface of the mask 13. Then, the elevation cylinders 26 and 27 are operated so that the scraping squeegee 31 and the scooping squeegee 33 are raised, and the printing squeegee 24 is lowered to be in contact with the upper surface of the mask 13 as shown in Fig. 1. In this state, the cream solder B is loaded on one side of the upper surface of the mask 13. The squeegee unit 20 is moved in the left and right direction, whereby the cream solder B is printed in a predetermined shape on the surface of the printed-circuit board A. Here, the scraping squeegee 31 and the scooping squeegee 33 are positioned on the upper side of the mask 13 and thus will not be in the way of the printing process performed by the printing squeegee 24.

The printed-circuit board A after the printing is conveyed to the next step by the carry-out conveyer, and the new printed-circuit board A conveyed from the carry-in conveyer is positioned on the lower surface of the mask 13. Similarly, the cream solder B is printed also on the surface of this printed-circuit board A, and the processing described above is repeated. When the predetermined printing process is completed and the printing is then performed on the printed-circuit board A with a different printing pattern, the mask 13 is replaced to a mask that conforms to the new printed-circuit board A. At the same time, processing of transferring the remaining cream solder B from the used mask 13 to the unused mask 13 is performed.

In this case, as shown in Fig. 1, the printing squeegee 24 pushes the cream solder B to the right side of the mask 13, and the squeegee unit 20 is moved so that the solder elevation head 25 is positioned on the upper side of the cream solder B. The scraping squeegee 31 is positioned at a left end of a movement range, and the scooping squeegee 33 is positioned at a right end of the movement range. Then, as shown in Fig. 3, the elevation cylinders 26 and 27 are operated so that the scraping squeegee 31 and the scooping squeegee 33 are lowered to have the lower ends thereof in contact with the surface of the mask 13. Thus, the cream solder B is sandwiched by the lower end portion of the scraping squeegee 31 and the distal end portion of the horizontal piece 33b of the scooping squeegee 33.

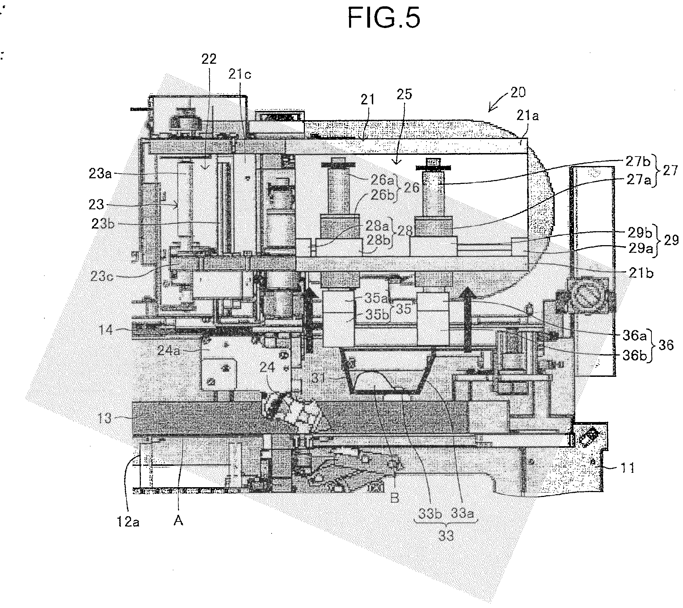

Then, the driving cylinder 29 is operated so that the scooping squeegee 33 is moved in the left direction together with the elevation cylinder 27. Thus, the cream solder B is scooped by the upper surface of the horizontal piece 33b of the scooping squeegee 33. Here, the cream solder B is prevented from moving in the left direction by the scraping squeegee 31, and is smoothly pushed up onto the upper surface of the horizontal piece 33b. The cream solder B is transferred onto the upper surface of the horizontal piece 33b while maintaining substantially the same shape as that in the state of being positioned on the mask 13. In this state, the elevation cylinders 26 and 27 are operated so that the scraping squeegee 31 and the scooping squeegee 33 are simultaneously raised, whereby the cream solder B is lifted as shown in Fig. 5. At this point, the elevation mechanism 23 is operated so that the printing squeegee 24 is also raised. Then, the mask 13 is replaced.

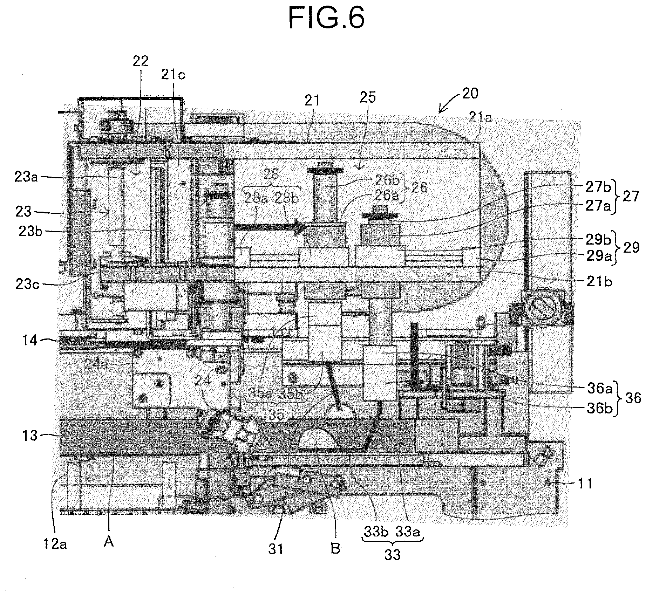

Then, as shown in Fig. 6, the elevation cylinder 27 is operated so that the scooping squeegee 33 is lowered together with the cream solder B. At the same time, the driving cylinder 28 is operated so that the scraping squeegee 31 is moved in the right direction. Thus, the scraping squeegee 31 is positioned more on the right side than the cream solder B in the left and right direction. Here, the covering portion 32 is disposed on the surface of the scraping squeegee 31, and thus the cream solder B almost never attaches to the scraping squeegee 31. Thereafter, the elevation cylinder 26 is operated so that the scraping squeegee 31 is lowered to have the lower end portion thereof in contact with the upper surface of the horizontal piece 33b. Then, the driving cylinder 29 is operated so that the scooping squeegee 33 moves in the right direction.

Thus, the scooping squeegee 33 moves in the right direction with the scraping squeegee 31 preventing the cream solder B from moving in the right direction. As a result, the cream solder B is scraped off from the upper surface of the horizontal piece 33b to be transferred onto the upper surface of the mask 13. Also in this case, the cream solder B is transferred onto the upper surface of the mask 13 while maintaining substantially the same shape as that in the state of being positioned on the horizontal piece 33b. Furthermore, also in this case, the covering portion 32 on the surface of the scraping squeegee 31 can prevent the cream solder B from attaching to the scraping squeegee 31.

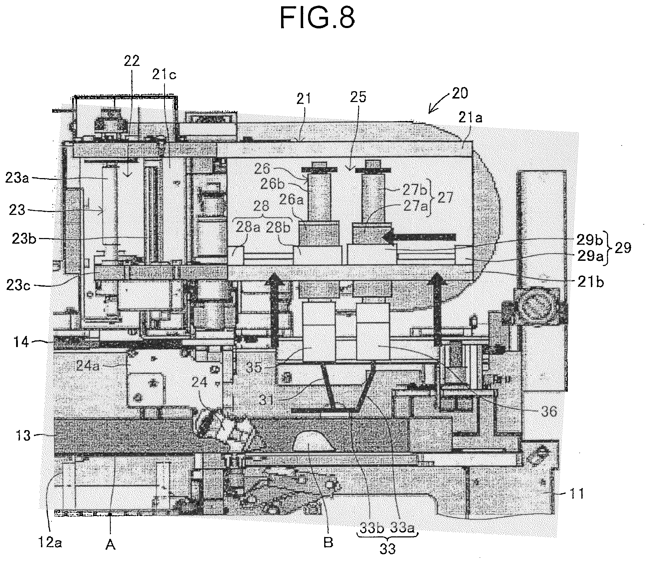

Then, the elevation cylinders 26 and 27 are operated so that the scraping squeegee 31 and the scooping squeegee 33 are raised. At the same time, the driving cylinder 29 is operated so that the scooping squeegee 33 is moved in the left direction, whereby a state shown in Fig. 8 is achieved. Thus, a series of processing is terminated.

As described above, in the printing machine 10 according to this embodiment, the printing squeegee 24, the scraping squeegee 31, and the scooping squeegee 33 reciprocate together through the head supporting portion 21. The scraping squeegee 31 and the scooping squeegee 33 can be moved toward and away from each other in the left and right direction by the driving cylinders 28 and 29. The scraping squeegee 31 and the scooping squeegee 33 can be separately moved in the upper and lower direction by the elevation cylinders 26 and 27.

Thus, the cream solder B pushed on one side on the upper surface of the mask 13 by the printing squeegee 24 can be transferred at once by being sandwiched and scooped by the scraping squeegee 31 and the scooping squeegee 33. Because the cream solder B can be transferred at once as described above, a shorter transferring time for the cream solder B at the time of replacing the mask 13 can be achieved. The transferring can be carried out without ruining the shape of the cream solder B. Thus, the cream solder B needs not to be reshaped when the new mask 13 is used, whereby an attempt to achieve shorter solder rolling time can be facilitated.

The scraping squeegee 31 is provided with the covering portion 32 formed of the nonwoven fabric having recesses and protrusions. Thus, the cream solder B is less likely to attach to the scraping squeegee 31. The scraping squeegee 31 and the scooping squeegee can be raised to or above the height of the frame of the mask by the elevation cylinders 26 and 27. Thus, when the printing squeegee 24 performs the printing process, the scraping squeegee 31 and the scooping squeegee do not come in the way. The mask 13 can be replaced while the cream solder B is being raised by the scraping squeegee 31 and the scooping squeegee 33.

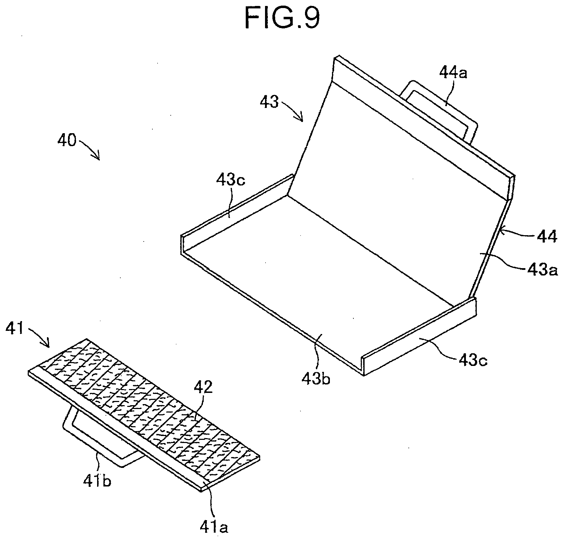

As another embodiment, an operator may perform a manual operation by using tools similar to the scraping squeegee 31 and the scooping squeegee 33. Here, a solder scooping tool 40 including a scraping tool 41 and a scooping tool 43 as shown in Fig. 9 may be used. The scraping tool 41 is formed by providing a gripped portion 41b at the center of an upper portion of a main body 41 in a horizontally long plate form that is formed similarly to the scraping squeegee 31, and attaching covering portions 42 on both sides of the main body 41a. A sponge in a form of a sheet is used as the covering portion 42.

The scooping tool 43 includes a main body 44. The main body 44 includes a horizontally long vertical piece 43a formed in a similar manner as the scooping squeegee 33, a horizontally long horizontal piece 43b inclined with respect to the vertical piece 43a and extending from a lower end of the vertical piece 43a, and side walls 43c formed on both sides of the horizontal piece 43b. The scooping tool 43 is formed with a gripped portion 44a formed at the center of an upper end of the vertical piece 43a of the main body 44.

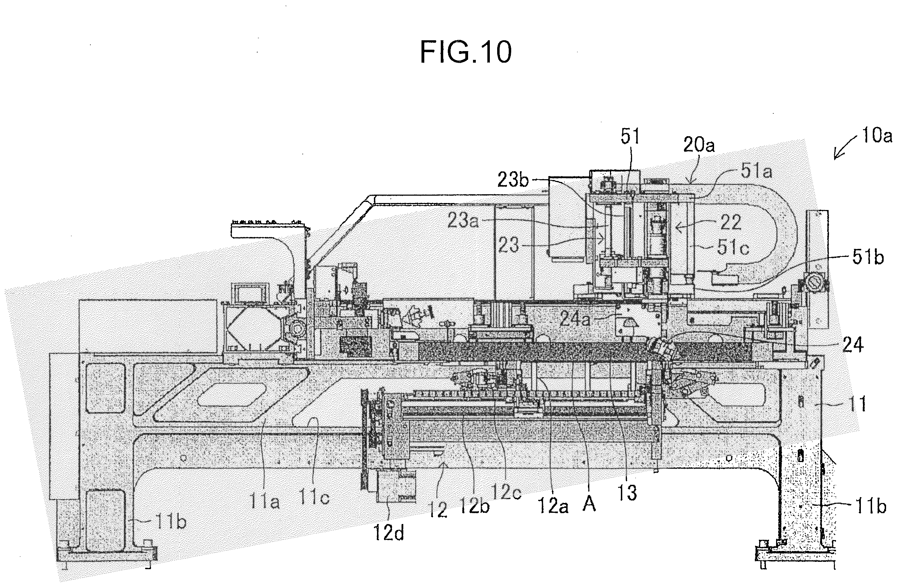

As a printing machine in which the solder scooping tool 40 having the configuration described above is used, a printing machine 10a including no solder elevation head 25 as shown in Fig. 10 is used, for example. In the printing machine 10a, the solder elevation head is not assembled and only the squeegee head 22 is assembled in a squeegee unit 20a. Thus, a head supporting portion 51 including an upper surface portion 51 a, a lower surface portion 51 b and a coupling piece 51c to couple portions 51a and 51 b is shorter than the head supporting portion 21 in the left and right direction. The configuration of other portions in the printing machine 10a is the same as that in the printing machine 10 described above. Thus, the same portion is denoted with the same reference numeral and will not be described.

In this embodiment, the operator holds and operates the solder scooping tool 40 with his or her hand when the cream solder B is transferred at the time of replacing the mask 13. When the cream solder B is transferred onto the solder scooping tool 40 from the upper surface of the mask 13, the scooping tool 43 is first placed near the cream solder B on the upper surface of the mask 13, and the cream solder B is loaded onto the upper surface of the mask 13 by the scraping tool 41. When the cream solder B is transferred onto the upper surface of the mask 13 from the upper surface of the horizontal piece 43b, the scraping tool 41 is slid toward the distal end side from a back side on the upper surface of the horizontal piece 43b to push the cream solder B onto the mask 13. Here, either one of the surfaces of the scraping tool 41 may be used.

In this embodiment, the printing machine 10a needs not to be provided with a mechanism for attaching the solder elevation head 25, whereby a conventional printing machine including no solder elevation head 25 can be used. The processing is performed by operation of the operator, and thus the operation can proceed while being checked. Thus, the cream solder B can be transferred without error. Furthermore, the operation can be performed regardless of the side on which the cream solder B has been pushed on the mask 13. Further operations and effects of this embodiment are the same as or similar to those of the printing machine 10 described above.

The printing machine according to the present invention is not limited to the embodiments described above and can be modified as appropriate to be implemented. For example, the covering portion 32 attached to the scraping squeegee 31 is formed of the nonwoven fabric in the embodiment described above. However, according to the invention, the covering portion 32 may be formed of a woven fabric or a sheet formed of a sponge. The covering portion 42 attached to the scraping tool 41 is formed of a sponge. Alternatively, the covering portion 42 may be formed of a nonwoven fabric or a woven fabric.

The scooping squeegee 33, which includes the vertical piece 33a and the horizontal piece 33b in the embodiment described above, may include only the vertical piece 33a with the horizontal piece 33b omitted. In this case, the scooping squeegee is preferably also provided with the covering portion. The vertical piece 43a in the scooping tool 43 may be omitted.

## Claims

1. A printing machine (10) that reciprocates a squeegee unit (20) including a printing squeegee in one direction on an upper surface of a mask (13) where a circuit board (A) is disposed on a lower side thereof to move solder thereby printing the solder on the circuit board (A),
the printing machine comprising:
a scraping squeegee (31) that reciprocates together with the squeegee unit (20) in a direction of a printing operation; and
a scooping squeegee (33) that reciprocates together with the squeegee unit (20) in the direction of the printing operation, wherein
the scraping squeegee (31) and the scooping squeegee (33) can relatively move toward and away from each other in the direction of the printing operation, in order to be capable of scooping the solder on the upper surface of the mask (13), and
**characterized in that**
the scraping squeegee (31) includes a main body (31a) and a covering portion (32), and
the covering portion (32) is a fabric or a sponge having recesses and protrusions that is attached to a surface of the scraping squeegee (31) facing the scooping squeegee (33), an opposite surface of the scraping squeegee (31) with respect to the surface that faces the scooping squeegee (33), and a lower end portion of the main body (31a).

2. The printing machine (10) according to claim 1, further comprising a frame that is disposed on an outer perimeter of the mask (13),
wherein the scraping squeegee (31) and the scooping squeegee (33) are able to be raised to or above the height of the frame of the mask (13).

3. The printing machine (10) according to claim 1 or 2, wherein the scraping squeegee (31) and the scooping squeegee (33) are able to be separately raised.

## Patentansprüche

1. Druckmaschine (10), die eine Rakeleinheit (20) mit einer Druckrakel in einer Richtung auf einer oberen Fläche einer Maske (13) hin und her bewegt, um Lot zu bewegen, wobei eine Schaltungsplatine (A) auf ihrer Unterseite angeordnet ist, wodurch das Lot auf die Schaltungsplatine (A) gedruckt wird,
wobei die Druckmaschine umfasst:
eine Schaberakel (31), die sich zusammen mit der Rakeleinheit (20) in einer Richtung eines Druckbetriebs hin und her bewegt; und
eine Aufnahmerakel (33), die sich zusammen mit der Rakeleinheit (20) in der Richtung eines Druckbetriebs hin und her bewegt; wobei
die Schaberakel (31) und die Aufnahmerakel (33) sich in der Richtung des Druckbetriebs relativ aufeinander zu und voneinander weg bewegen können, um fähig zu sein, das Lot auf der oberen Fläche der Maske (13) aufzunehmen, und
**dadurch gekennzeichnet, dass**
die Schaberakel (31) einen Hauptkörper (31 a) und einen Abdeckabschnitt (32) umfasst, und
der Abdeckabschnitt (32) ein Gewebe oder ein Schwamm mit Vertiefungen und Vorsprüngen ist, das/der an einer Fläche der Schaberakel (31), die der Aufnahmerakel (33) zugewandt ist, einer entgegengesetzten Fläche der Schaberakel (31) in Bezug auf die Fläche, die der Aufnahmerakel (33) zugewandt ist, und einem unteren Endabschnitt des Hauptkörpers (31 a) angebracht ist.

2. Druckmaschine (10) nach Anspruch 1, die ferner einen Rahmen umfasst, der auf einem Außenumfang der Maske (13) angeordnet ist,
wobei die Schaberakel (31) und die Aufnahmerakel (33) fähig sind, auf oder über die Höhe des Rahmens der Maske (13) erhöht zu werden.

3. Druckmaschine (10) nach Anspruch 1 oder 2, wobei die Schaberakel (31) und die Aufnahmerakel (33) fähig sind, getrennt erhöht zu werden.

## Revendications

1. Machine d'impression (10) qui effectue un mouvement de va-et-vient à une unité de raclette (20), qui comprend une raclette d'impression, dans une direction sur une surface supérieure d'un masque (13) dans lequel une carte de circuit imprimé (A) est placée sur un côté inférieur de celui-ci pour déplacer une brasure, imprimant ainsi la brasure sur la carte de circuit imprimé (A),
la machine d'impression comprenant :
une raclette de grattage (31) qui effectue un mouvement de va-et-vient avec l'unité de raclette (20) dans une direction d'une opération d'impression ; et
une raclette de soulèvement (33) qui effectue un mouvement de va-et-vient avec l'unité de raclette (20) dans la direction de l'opération d'impression, dans laquelle
la raclette de grattage (31) et la raclette de soulèvement (33) peuvent se déplacer relativement en se rapprochant et en s'éloignant l'une de l'autre dans la direction de l'opération d'impression, pour pouvoir soulever la brasure sur la surface supérieure du masque (13), et
**caractérisée en ce que**
la raclette de grattage (31) comprend un corps principal (31 a) et une partie de revêtement (32), et
la partie de revêtement (32) est un tissu ou une éponge avec des évidements et des saillies, qui est attaché à une surface de la raclette de grattage (31) qui fait face à la raclette de soulèvement (33), une surface opposée de la raclette de grattage (31) par rapport à la surface qui fait face à la raclette de soulèvement (33), et une partie d'extrémité inférieure du corps principal (31 a).

2. Machine d'impression (10) selon la revendication 1, comprenant en outre un bâti qui est placé sur un périmètre extérieur du masque (13),
dans laquelle la raclette de grattage (31) et la raclette de soulèvement (33) peuvent être soulevées jusqu'à la hauteur du bâti du masque (13) ou au-dessus de celui-ci.

3. Machine d'impression (10) selon la revendication 1 ou 2, dans laquelle la raclette de grattage (31) et la raclette de soulèvement (33) peuvent être soulevées séparément.
